# EUROPÄISCHE PATENTSCHRIFT

(11) **EP 3 669 199 B1**
(45) Veröffentlichungstag und Bekanntmachung des Hinweises auf die Patenterteilung: **25.01.2023**
(21) Anmeldenummer: 18800834.6
(22) Anmeldetag: 24.10.2018
(51) Int. Cl.: G01R 31/40, G01R 35/00, G01R 31/367, G01R 31/396, G05B 13/04, G01R 31/382, G01R 31/00, G01R 31/28

(54) **VORRICHTUNG UND VERFAHREN ZUM KALIBRIEREN EINES BATTERIESIMULATORS**
APPARATUS AND METHOD OF CALIBRATING A BATTERY SIMULATOR
DISPOSITIF ET PROCÉDÉ D'ÉTALONNAGE D'UN SIMULATEUR DE BATTERIE

(30) Priorität: 25.10.2017 AT 508952017
(43) Veröffentlichungstag der Anmeldung: 24.06.2020
(73) Patentinhaber: Kristl, Seibt & Co. Gesellschaft m.b.H., 8052 Graz (AT)
(72) Erfinder: GÖLDNER, Arthur, 9583 Faak am See (AT); AUER, Christian, 8020 Graz (AT); HAIDINGER, Thomas, 8075 Hart bei Graz (AT); PIRCHER, Stefan, 8042 Graz (AT)
(74) Vertreter: SONN Patentanwälte OG
(86) Internationale Anmeldenummer: PCT/AT2018/060256
(87) Internationale Veröffentlichungsnummer: WO 2019/079836

(56) Entgegenhaltungen:
- CN-A- 102 033 176
- CN-B- 103 345 163
- DE-A1-102010 031 884
- DE-A1-102014 207 520
- DE-A1-102014 226 190
- DE-U1- 29 621 472
- KR-A- 20150 139 346
- US-A1- 2006 273 800
- US-A1- 2012 176 258
- US-A1- 2014 077 783
- US-A1- 2015 268 285
- US-A1- 2015 301 120
- US-B1- 6 504 395
- US-B1- 8 138 822
- EHTESHAM BUSHRA ET AL: "Development of an Automated Precision Direct Current Source for Generation of pA Currents Based on Capacitance Charging Method at CSIR-NPL", MAPAN, SPRINGER INDIA, INDIA, Bd. 32, Nr. 1, 19. August 2016 (2016-08-19), Seiten 17-22, XP036175744, ISSN: 0970-3950, DOI: 10.1007/S12647-016-0186-0 [gefunden am 2016-08-19]

## Beschreibung

Die Erfindung betrifft ein System aufweisend eine Vorrichtung zum Kalibrieren eines Batteriesimulators mit einem zumindest einen Kondensator aufweisenden Strompfad und einer Vorrichtung (Stromstärkemessvorrichtung) zur Messung der Stromstärke in dem Strompfad. Weiters betrifft die Erfindung ein Verfahren zum Kalibrieren eines Batteriesimulators, bei dem zumindest ein Kondensator vom Batteriesimulator geladen wird und in diesen entladen wird, wobei die Stromstärke gemessen wird.

Batteriesimulatoren werden in der Forschung und Entwicklung von Systemen benützt, welche Batterien beinhalten. Gerade in der Automobilindustrie gewinnen elektrische Antriebe, insbesondere in Elektro- und Hybridfahrzeugen, zunehmend an Bedeutung. Die dabei verwendeten Batterien werden meistens durch Batteriesimulatoren, die heutzutage in der Regel ein Teil des Prüfstandes sind, ersetzt. Ein Batteriesimulator ist üblicherweise eine dynamische Gleichstrom- und Gleichspannungsquelle, die auch als Stromsenke dienen kann. Es wird dabei eine Batterie simuliert, indem eine Spannung von bis zu mehreren hundert Volt konstant oder stromabhängig, einem Simulationsmodell einer Batterie folgend, zur Verfügung gestellt wird. Hierbei kann der Strom in positiver Zählrichtung, d.h. wenn der Batteriesimulator Leistung abgibt, als auch in negativer Zählrichtung, d.h. wenn der Batteriesimulator Leistung aufnimmt, bis zu mehreren hundert Ampere betragen. Zur Regelung des Batteriesimulators werden Spannung und Strom mit geeigneten internen Messsystemen im Batteriesimulator gemessen, wobei diese Messsysteme von Zeit zu Zeit kalibriert werden müssen.

Batteriesimulatoren, welche größere Batterien wie beispielsweise eine Autobatterie simulieren sollen, sind in der Regel sehr groß und schwer und aufgrund dessen ortsfest. Ein solches Gerät kann daher nicht oder nur unter großem Aufwand an ein Kalibrierinstitut gesendet werden, weshalb es notwendig oder bevorzugt ist, dieses vor Ort zu kalibrieren. Im Stand der Technik sind grundsätzlich zahlreiche Methoden und Geräte bekannt, um die einzelnen Messgeräte eines Batteriesimulators zu kalibrieren. Insbesondere die Spannungsmessung ist mit Methoden aus dem Stand der Technik einfach zu verwirklichen. Weiters sind Methoden und Geräte zum Simulieren von Batterien oder Batteriemanagementsystemen bekannt, bei denen Kondensatoren zum Einsatz kommen.

Aus der DE 102014207520 A1 ist eine elektronische Schaltung für einen Prüfstand zum Testen von Batteriesystemen oder Batteriemanagementsystemen bekannt, die einen Simulationsstrang mit einem Kondensator umfasst, der das Nachbilden eines Spannungsverlaufes beim Vorladen eines Zwischenkreises erlaubt, wenn eine Ladegleichspannung angelegt wird. Parallel zum Simulationsstrang ist ein weiterer Strang geschaltet, der das sichere Entladen des Kondensators nach Trennen der Ladegleichspannung erlaubt.

Weiters ist aus der DE 102014226190 A1 eine Testvorrichtung zum Überprüfen eines Batterie-Steuergerätes oder einer Batterie mit zumindest einer Zelle bekannt. Die Testvorrichtung weist dabei einen Batteriesimulator zur Simulation einer Spannung einer Zelle einer simulierten Batterie zur Vorgabe an das Batterie-Steuergerät auf, wobei das Batterie-Steuergerät oder die Batterie mit einem Auswertemodul zur Bearbeitung und Überprüfung u.a. der Spannung der Zelle verbunden ist. Die Testvorrichtung kann weiters den Ausgleichsstrom, der dafür sorgt, dass zwischen den Zellen einer aus mehreren Zellen zusammengesetzten Batterie eine gleichmäßige Spannung vorliegt, steuern. In einer bevorzugten Ausführungsform ist ein Kondensator zur Zwischenspeicherung einer Spannung für den Ausgleichsstrom im Auswertemodul vorgesehen.

Weiters zeigt die US 8,138,822 B1 eine Vorrichtung zum Kalibrieren von schaltenden Stromquellen. Dabei soll ein Nichtübereinstimmen zweier Stromquellen detektiert werden.

Des Weiteren zeigt die DE 10 2014 226 190 A1 eine Testvorrichtung zur Überprüfung eines Batterie-Steuergerätes oder einer Batterie. Sie umfasst einen Batteriesimulator zur Simulation einer Spannung mindestens einer Zelle einer simulierten Batterie zur Vorgabe an das Batterie-Steuergerät.

Weiters zeigt die DE 296 21 472 U1 einen Batteriesimulator für die Simulation von Gerätebatterien, bspw. Autobatterien, die bei einer variablen Spannung einen konstanten Strom benötigen, wobei das komplette Ladegerät einschließlich des Steuerteils und des Leistungsteils geprüft werden soll.

Des Weiteren zeigt die US 2015/0301120 A1 einen Batteriesimulator, der dazu ausgebildet sein soll, große Energieimpulse für ein Hot-Plug-Prüfen bereitzustellen und gleichzeitig die Fähigkeit zu bewahren schnell anzusprechen, während Prüfungen in zufälliger Reihenfolge erfolgen.

Es sind im Stand der Technik jedoch keine Vorrichtungen oder Verfahren offenbart, welche die Kalibrierung des Gesamtsystems eines Batteriesimulators ermöglichen. Insbesondere die Kalibrierung der negativen Ströme, also des generatorischen Betriebes der Kalibriervorrichtung, d.h. jenes Zustandes in dem der zu kalibrierende Batteriesimulator als Stromsenke fungiert, gestaltet sich problematisch. Eine geeignete Vorrichtung müsste einerseits in der Lage sein, sehr hohe Ströme aufzunehmen, andererseits sollte es auch in der Lage sein, entsprechend hohe Ströme zu liefern. Mit den im Stand der Technik bekannten Vorrichtungen und Verfahren wäre eine weitere Stromquelle, z.B. ein weiterer Batteriesimulator, erforderlich, damit diese den Strom bereitstellt, der in den zu kalibrierenden Batteriesimulator, der als Stromsenke fungiert, eingespeist wird.

Ziel der vorliegenden Erfindung ist es demnach eine Vorrichtung und ein Verfahren zum Kalibrieren eines Batteriesimulators zu schaffen, bei welcher bzw. bei welchem die Anforderung einer zusätzlichen Stromquelle vermieden wird. Insbesondere soll eine Vorrichtung geschaffen werden, die einfach und mobil ist und sich zur automatischen Kalibrierung von Batteriesimulatoren eignet.

Erfindungsgemäß wird dies mit einem System gemäß Anspruch 1 erzielt. Die Vorrichtung des Systems der eingangs angeführten Art weist einen Eingang und einen Ausgang zum Anschließen eines Batteriesimulators auf, wobei vom Eingang zum Ausgang ein Strompfad verläuft, der eine Vorrichtung (Stromstärkemessvorrichtung) zum Messen der Stromstärke aufweist, und in dem zumindest ein Kondensator geschaltet ist. Der zumindest eine Kondensator kann dabei insbesondere als Kondensatorbatterie ausgeführt sein. Somit kann die Kalibriervorrichtung beim Laden des zumindest einen Kondensators sehr hohe Ströme aufnehmen und beim anschließenden Entladen des zumindest einen Kondensators sehr hohe Ströme liefern, während die Stromstärke gemessen wird. Dadurch ist eine bidirektionale Kalibrierung des Stromes sehr effizient und präzise möglich. Kondensatoren haben im Vergleich zu Batterien eine höhere Leistungsdichte bei gleichzeitig niedrigerer Energiedichte, wobei Ersteres bei der Kalibrierung von Batteriesimulatoren von größerer Bedeutung ist.

Der Batteriesimulator, der insbesondere mit der hierin beschriebenen Vorrichtung kalibriert werden kann, weist üblicherweise eine Gleichspannungsquelle und -senke sowie eine Gleichstromquelle und -senke auf. Auf diese Weise kann sowohl der generatorische, d.h. der leistungsabgebende bzw. die Batterie entladende, Betrieb, als auch der motorische, d.h. der leistungsaufnehmende bzw. die Batterie ladende, Betrieb einer Batterie simuliert werden.

Bevorzugt ist der Batteriesimulator geeignet, sowohl hohe Spannungen bis zu mehreren hundert Volt, als auch hohe Ströme in positiver wie in negativer Zählrichtung, d.h. generatorisch wie auch motorisch, bis zu mehreren hundert Ampere abzugeben.

Zur Regelung des Batteriesimulators werden vorzugsweise die Spannung und die Stromstärke mit geeigneten internen Messsystemen im Batteriesimulator gemessen. Dies ist auch vorteilhaft, da die vom Batteriesimulator abgegebene Spannung entweder konstant oder stromabhängig, entsprechend einem Simulationsmodell einer Batterie, sein soll.

Es ist weiters vorteilhaft, wenn die Vorrichtung zum Kalibrieren des Batteriesimulators nicht nur die Stromstärke, sondern auch die Spannung messen kann, da dies einen wichtigen Schritt zur Kalibrierung des Gesamtsystems des Batteriesimulators mithilfe einer einzigen Vorrichtung darstellt. Eine solche Möglichkeit zum Messen der Spannung ist darüber hinaus günstig, um die stromabhängige Bereitstellung der Spannung durch den Batteriesimulator zu kalibrieren. Dafür ist vorgesehen, dass parallel zum Strompfad noch ein Spannungspfad existiert, an dem eine Vorrichtung zum Messen der Spannung an diesem Pfad vorgesehen ist. Der Spannungspfad verläuft somit bevorzugt vom Eingang zum Ausgang der Vorrichtung zum Kalibrieren des Batteriesimulators. Die Spannung wird bevorzugt an mehreren Messpunkten, welche den ganzen Spannungsbereich abdecken, gemessen.

Bekanntermaßen ist die Messung sehr hoher Ströme mit einem Strommessgerät problematisch. Insbesondere bei (direkter) Messung mit einem Messwiderstand wäre die Verlustleistung sehr groß. Somit ist in einer bevorzugten Ausführungsform der Vorrichtung ein Stromwandler mit einem Primär- und einem Sekundärstrom in den Strompfad geschaltet, wobei der Sekundärstrom zur Vorrichtung zum Messen der Stromstärke und der Primärstrom zum Kondensator läuft. Als Stromwandler ist bevorzugt ein Kompensationsstromwandler vorgesehen. Der Sekundärstrom entspricht dabei einem genau festgelegten Bruchteil des Primärstroms, beispielsweise einem Tausendstel oder einem Fünftausendstel. Der Sekundärstrom liegt beispielsweise in der Größenordnung von einigen wenigen Ampere. Der Sekundärstrom kann nun mit einer Strommesseinrichtung relativ einfach gemessen werden, da der Sekundärstrom vom Primärstrom galvanisch getrennt und deutlich kleiner als dieser ist.

In einer weiteren Ausführungsform der zuletzt genannten bevorzugten Ausführungsform weist die Vorrichtung zum Messen der Stromstärke einen Messwiderstand auf, dem eine Vorrichtung zum Messen der elektrischen Spannung parallelgeschaltet ist. Der Stromwandler und die Messung an dessen Sekundärstrom sorgen dafür, dass die Verlustleistung am Messwiderstand nicht zu groß ist.

Vorzugsweise ist im Strompfad nach dem Eingang ein Eingangsschütz und/oder vor dem Ausgang ein Ausgangsschütz geschaltet. Somit kann die Spannung am Spannungspfad auch bei unterbrochenem Strompfad, d.h. bei geöffneten Schützen, erfolgen. In einer bevorzugten Ausführungsform verläuft der Strompfad somit vom Eingang über den Eingangsschütz weiter über den Stromwandler und den Kondensator über den Ausgangsschütz zum Ausgang. Günstigerweise soll die beschriebene Erfindung pro Messkanal über je einen Eingang und je einen Ausgang verfügen, die alle jeweils mit einem Schütz im jeweiligen Strompfad verbunden sind, wobei der jeweilige Spannungspfad parallel dazu vom jeweiligen Eingang zum jeweiligen Ausgang verläuft.

Um eine vollautomatische Kalibrierung zu ermöglichen, soll die Kalibriervorrichtung in einer bevorzugten Ausführungsform mit den Abgängen des zu kalibrierenden Batteriesimulators verbindbar sein. Dafür soll die Vorrichtung eine Kommunikationsschnittstelle aufweisen. Diese kann beispielsweise als RJ-45-Buchse ausgeführt werden, auf der das EtherCAT-Protokoll zum Einsatz kommen kann.

Um eine vollautomatische Justierung und Kalibrierung zu ermöglichen ist in einer weiteren bevorzugten Ausführungsform der zuletzt genannten bevorzugten Ausführungsform vorgesehen, dass zwischen dem Batteriesimulator und der Vorrichtung ein Regelkreis besteht. Dabei werden die Ergebnisse der internen Messgeräte des Batteriesimulators mit den entsprechenden Messvorrichtungen der Kalibriervorrichtung verglichen und dementsprechend die Messgeräte des Batteriesimulators justiert. Die Verwendung digitaler Messgeräte in der Kalibriervorrichtung ermöglicht die automatische Verarbeitung und Speicherung der Mess- und Kalibrierdaten. Optional können die Ergebnisse des Kalibriervorgangs auf einem an die Vorrichtung angeschlossenen oder in die Vorrichtung integrierten Speichermedium gespeichert werden. Es kann somit insbesondere nach dem Verstreichen einer Vorwärmzeit der Kalibriervorgang oder Justier- und Kalibriervorgang gestartet werden, wobei dann der Kalibriervorgang oder Justier- und Kalibriervorgang selbst automatisch abläuft.

Damit eine möglichst lange Messzeit erzielt werden kann, wird als der zumindest eine Kondensator, der auch als Kondensatorbatterie ausgeführt sein kann, in einer bevorzugten Ausführungsform ein Kondensator bzw. eine Kondensatorbatterie mit einer Gesamtkapazität von mehr als 10 Farad, bevorzugt von mehr als 100 Farad, insbesondere von mehr als 1000 Farad verwendet.

Bevorzugt wird für den zumindest einen Kondensator ein elektrochemischer Kondensator, der bekanntermaßen eine hohe Kapazität pro Bauteil hat, oder eine Zusammenschaltung solcher verwendet. Somit wird wiederum eine möglichst lange Messzeit erzielt.

Vorzugsweise ist der elektrochemische Kondensator als Superkondensator, Supercap oder Ultrakondensator ausgebildet. Bekanntermaßen haben Superkondensatoren typischerweise 10000-fach höhere Kapazitätswerte pro Bauteil als z.B. Elektrolytkondensatoren, wodurch wiederum eine möglichst lange Messzeit erzielt wird.

Die Erfindung betrifft weiter ein Verfahren gemäß Anspruch 13, zum Kalibrieren eines Batteriesimulators, mit einer Vorrichtung mit einem Eingang und einem Ausgang, wobei zwischen Eingang und Ausgang ein Strompfad vorgesehen ist, an dem die Stromstärke gemessen wird. Im Strompfad ist ein Kondensator geschaltet. Dieser wird bei dem erfindungsgemäßen Verfahren vom Batteriesimulator zumindest teilweise geladen und anschließend zumindest teilweise in den Batteriesimulator entladen. Es wird also der Umstand ausgenützt, dass es sich bei einem Batteriesimulator sowohl um eine Gleichstromquelle, als auch um eine Gleichstromsenke handelt. Somit ist keine zusätzliche Gleichstromquelle notwendig, um den motorischen, d.h. Leistung aufnehmenden, Betrieb des Batteriesimulators zu testen.

Vorzugsweise sind im Strompfad nach dem Eingang ein Eingangsschütz und vor dem Ausgang ein Ausgangsschütz geschaltet. Dann kann in einem zum Strompfad parallel verlaufenden Spannungspfad eine Spannungsmessung bei unterbrochenem Strompfad durchgeführt werden. D.h. die Spannung wird, vorteilhafterweise an mehreren Messpunkten, im Leerlauf gemessen.

Es ist wünschenswert, dass der Kalibriervorgang oder Justier- und Kalibriervorgang automatisch ablaufen kann. Dafür ist bevorzugt vorgesehen, dass mit Hilfe einer Kommunikationsschnittstelle ein Regelkreis zum Batteriesimulator besteht. Es werden dann die vom Batteriesimulator gemessenen Spannungen und Stromstärken mit den im Spannungs- und im Strompfad gemessenen verglichen und die Messgeräte des Batteriesimulators derart justiert, dass keine Abweichungen zwischen den vom Batteriesimulator gemessenen Größen und den im Strom- und Spannungspfad gemessenen Größen mehr besteht.

Die hierin beschriebene Erfindung eignet sich insbesondere zum Einsatz in der Automobilindustrie, speziell für einen in einen Prüfstand integrierten Batteriesimulator, soll jedoch nicht auf dieses Einsatzgebiet beschränkt bleiben. Weiters eignet sich die Erfindung insbesondere zur Implementierung in einem mobilen Gerät, wobei als Gehäuse des Geräts ein stabiler Transportkoffer verwendet werden kann.

Die Erfindung wird nachstehend anhand von in den Zeichnungen dargestellten bevorzugten Ausführungsbeispielen, auf welche sie jedoch keinesfalls beschränkt sein soll, noch näher erläutert. Im Einzelnen zeigen in den Zeichnungen:
Fig. 1 einen Schaltkreis einer Ausführungsform einer erfindungsgemäßen Vorrichtung zum Kalibrieren eines Batteriesimulators mit einem Strompfad und eines mit dieser verbundenen Batteriesimulators; und
Fig. 2 einen Schaltkreis einer bevorzugten Ausführungsform der erfindungsgemäßen Vorrichtung zum Kalibrieren eines Batteriesimulators mit einem Strom- und einem Spannungspfad.

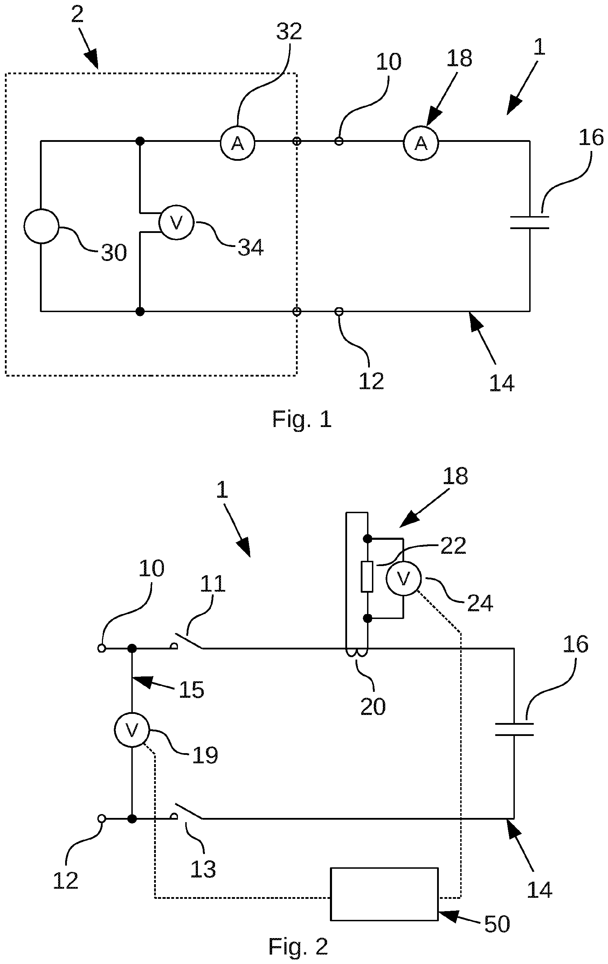

Fig. 1 zeigt eine Ausführungsform der Vorrichtung 1 zum Kalibrieren eines Batteriesimulators und eine Ausführungsform eines Batteriesimulators 2. Die Vorrichtung weist einen Eingang 10 und einen Ausgang 12 auf. Zwischen diesen verläuft ein Strompfad 14, in dem ein Kondensator 16 und eine Vorrichtung 18 zum Messen der Stromstärke geschaltet sind. Die Vorrichtung 1 zum Kalibrieren eines Batteriesimulators ist mit einem Batteriesimulator 2 verbunden. Dieser weist eine Gleichspannungsquelle und -senke und/oder Gleichstromquelle und -senke 30, ein in Serie geschaltetes Strommessgerät 32 und ein parallel geschaltetes Spannungsmessgerät 34 auf.

Bei der gezeigten Ausführungsform stellt die Gleichspannungsquelle und -senke und/oder Gleichstromquelle und -senke 30 des Batteriesimulators 2 anfangs eine Gleichspannung zur Verfügung, die z.B. konstant oder stromabhängig, einem Simulationsmodell einer beliebigen Batterie folgend, sein kann und die mithilfe des internen Strommessgeräts 32 und Spannungsmessgeräts 34 des Batteriesimulators 2 eingestellt wird. Infolgedessen wird der Kondensator 16 der Vorrichtung 1 zum Kalibrieren eines Batteriesimulators aufgeladen und Energie in diesem gespeichert; dies entspricht einem Motorbetriebsmodus der Vorrichtung 1 zum Kalibrieren eines Batteriesimulators. Anschließend wird der Kondensator 16 in den Batteriesimulator 2 entladen; dies entspricht dem Generatorbetriebsmodus der Vorrichtung 1 zum Kalibrieren eines Batteriesimulators. Während des Motor- und/oder des Generatorbetriebsmodus wird die Stromstärke im Strompfad 14 von der Vorrichtung 18 zum Messen der Stromstärke gemessen. Anhand der Messergebnisse der Vorrichtung 18 zum Messen der Stromstärke kann das Strommessgerät 32 des Batteriesimulators 2 kalibriert werden.

Fig. 2 zeigt eine weitere bevorzugte Ausführungsform der Vorrichtung 1 zum Kalibrieren eines Batteriesimulators. Mit dem Eingang 10 und dem Ausgang 12 sind in Parallelschaltung ein Strompfad 14 und ein Spannungspfad 15 verbunden. In den Spannungspfad 15 ist eine Vorrichtung 19 zum Messen der elektrischen Spannung geschaltet. Der Strompfad verläuft über einen Eingangsschütz 11 zu einem Stromwandler 20, dessen Sekundärstrom über eine Vorrichtung 18 zum Messen der Stromstärke verläuft. Der Primärstrom des Stromwandlers 20 verläuft weiters über den Kondensator 16 zum Ausgangsschütz 13. Die Vorrichtung 18 zum Messen der Stromstärke besteht aus einem Messwiderstand 22, dem eine {weitere} Vorrichtung 24 zum Messen der elektrischen Spannung parallelgeschaltet ist.

Es ist vorgesehen, dass ein Batteriesimulator an den Eingang 10 und den Ausgang 12 angeschlossen wird. Dann können Stromstärke und Spannung gemessen werden, während die Vorrichtung wie bereits erläutert im Motor- und im Generatorbetriebsmodus betrieben wird. Für die Stromstärkenmessung gibt der Stromwandler 20 einen zum Primärstrom proportional geringeren Sekundärstrom an die Vorrichtung 18 zum Messen der Stromstärke ab. Diese Vorrichtung 18 zum Messen der Stromstärke ist hier als Parallelschaltung eines Messwiderstandes 22 und einer Vorrichtung 24 zum Messen der elektrischen Spannung ausgebildet. Weiters kann auch bei geöffneten Schützen 11, 13 eine Spannungsmessung im Leerlauf erfolgen. Anhand der Messergebnisse der Vorrichtung 18 zum Messen der Stromstärke und der Vorrichtung 19 zum Messen der Spannung können die internen Messgeräte eines angeschlossenen Batteriesimulators kalibriert werden.

Weiters zeigt die Fig. 2 eine Kommunikationsschnittstelle 50, deren beispielhaften Verbindungen mit der Vorrichtung 19 zum Messen der Spannung und der Vorrichtung 24 zum Messen der Spannung, die Teil der Vorrichtung 18 zum Messen der Stromstärke ist, mit strichlierten Linien angedeutet sind. Es ist in einer bevorzugten Ausführungsform vorgesehen, dass diese Kommunikationsschnittstelle 50 dazu dient einen Regelkreis zwischen der Vorrichtung 1 zum Kalibrieren eines Batteriesimulators und dem zu kalibrierenden Batteriesimulator herzustellen und dass die vom Batteriesimulator gemessenen Größen mit den im Spannungspfad 15 und im Strompfad 14 gemessenen Größen verglichen werden und bei Abweichungen zwischen den vom Batteriesimulator gemessenen Größen und den im Spannungspfad 15 und im Strompfad 14 gemessenen Größen die Messgeräte des Batteriesimulators entsprechend der im Spannungspfad 15 und im Strompfad 14 gemessenen Größen justiert werden. Insbesondere kann somit die Justierung und Kalibrierung des Batteriesimulators automatisch ausgeführt werden.

Die in den Figuren dargestellten und im Zusammenhang mit diesen erläuterten Ausführungsbeispiele dienen der Erläuterung der Erfindung und sind für diese nicht beschränkend.

## Patentansprüche

1. System, aufweisend
a) einen Batteriesimulator (2) mit einer Gleichspannungsquelle und -senke und/oder einer Gleichstromquelle und -senke (30); und
b) eine Vorrichtung (1), die dazu eingerichtet ist, den Batteriesimulator (2) zu kalibrieren, und die einen Eingang (10) und einen Ausgang (12) zum Anschließen des Batteriesimulators (2) aufweist, wobei zwischen Eingang (10) und Ausgang (12) ein Strompfad (14) mit einer Stromstärkemessvorrichtung (18) zum Messen der Stromstärke im Strompfad (14) vorgesehen ist, und wobei in dem Strompfad (14) der Vorrichtung (1) zumindest ein Kondensator (16) geschaltet ist.

2. System nach Anspruch 1, wobei der Batteriesimulator (2) geeignet ist Spannungen von über 100 Volt und/oder Ströme von über 100 Ampere aufzunehmen oder abzugeben.

3. System nach einem der vorhergehenden Ansprüche, wobei der Batteriesimulator (2) ein Strommessgerät (32) und/oder ein Spannungsmessgerät (34) aufweist.

4. System nach einem der vorhergehenden Ansprüche, wobei die Vorrichtung (1) in einem Motorbetriebsmodus und in einem Generatorbetriebsmodus betreibbar ist, wobei im Motorbetriebsmodus der zumindest eine Kondensator (16) vom Batteriesimulator (2) aufgeladen wird und im Generatorbetriebsmodus der Kondensator (16) in den Batteriesimulator (2) entladen wird, wobei die Stromstärke gemessen wird.

5. System nach einem der vorhergehenden Ansprüche, wobei eine Vorrichtung (19) zum Messen der elektrischen Spannung in einem Spannungspfad (15) zwischen Eingang (10) und Ausgang (12) vorgesehen ist.

6. System nach einem der vorhergehenden Ansprüche, wobei in dem Strompfad (14) ein Stromwandler (20) mit einem Primär- und einem Sekundärstrom geschaltet ist, wobei der Sekundärstrom zur Stromstärkemessvorrichtung (18) zum Messen der Stromstärke und der Primärstrom zum Kondensator (16) läuft.

7. System nach Anspruch 6, wobei die Stromstärkemessvorrichtung (18) zum Messen der elektrischen Stromstärke einen Messwiderstand (22) aufweist, dem eine Vorrichtung (24) zum Messen der elektrischen Spannung an diesem parallelgeschaltet ist.

8. System nach einem der vorhergehenden Ansprüche, wobei im Strompfad (14) nach dem Eingang (10) ein Eingangsschütz (11) und/oder vor dem Ausgang (12) ein Ausgangsschütz (13) in Serie geschaltet ist.

9. System nach einem der vorhergehenden Ansprüche, wobei eine Kommunikationsschnittstelle (50) zur Kommunikation mit dem Batteriesimulator (2) vorgesehen ist.

10. System nach Anspruch 9, wobei mit der Kommunikationsschnittstelle (50) ein Regelkreis zwischen dem Batteriesimulator (2) und der Vorrichtung (1) hergestellt werden kann, wobei die von der Vorrichtung (1) gemessenen Größen und die vom Batteriesimulator (2) gemessenen Größen kontinuierlich verglichen werden und die Messvorrichtungen (32, 34) des Batteriesimulators bei einer Abweichung der vom Batteriesimulator (2) und von der Vorrichtung (1) gemessenen Größen entsprechend der von der Vorrichtung (1) gemessenen Größen justiert werden.

11. System nach einem der vorhergehenden Ansprüche, wobei der zumindest eine Kondensator (16) eine Gesamtkapazität von über 10 Farad, insbesondere von über 100 Farad, bevorzugt von über 1000 Farad aufweist.

12. System nach einem der vorhergehenden Ansprüche, wobei der Kondensator (16) zumindest einen elektrochemischen Kondensator, insbesondere zumindest einen Superkondensator, aufweist.

13. Verfahren zum Kalibrieren eines Batteriesimulators (2) mit einer Vorrichtung (1) mit einem Eingang (10) und einem Ausgang (12) zum Anschließen des Batteriesimulators (2), wobei zwischen Eingang (10) und Ausgang (12) ein Strompfad (14) vorgesehen ist, dessen Stromstärke gemessen wird, wobei ein Kondensator (16) im Strompfad (14) vom Batteriesimulator (2) zumindest teilweise aufgeladen wird und anschließend der Kondensator (16) den Batteriesimulator (2) zumindest teilweise lädt.

14. Verfahren nach Anspruch 13, wobei der Strompfad (14) nach dem Eingang (10) mit einem Eingangsschütz (11) und/oder vor dem Ausgang (12) mit einem Ausgangsschütz (13) unterbrochen wird, wenn eine Messung der Spannung an einem Spannungspfad (15) zwischen dem Eingang (10) und dem Ausgang (12) durchgeführt wird.

15. Kalibrierverfahren nach Anspruch 14, wobei mit Hilfe einer Kommunikationsschnittstelle (50) ein Regelkreis zum Batteriesimulator (2) besteht und wobei die vom Batteriesimulator (2) gemessenen Größen mit den im Spannungspfad (15) und im Strompfad (14) gemessenen Größen verglichen werden und bei Abweichungen zwischen den vom Batteriesimulator (2) gemessenen Größen und den im Spannungspfad (15) und im Strompfad (14) gemessenen Größen Messgeräte (32, 34) des Batteriesimulators (2) entsprechend der im Spannungspfad (15) und im Strompfad (14) gemessenen Größen justiert werden.

## Claims

1. System, comprising
a) a battery simulator (2) having a DC voltage source and sink and/or a direct current source and sink (30); and
b) an apparatus (1) which is designed to calibrate the battery simulator (2) and which has an input (10) and an output (12) for connecting the battery simulator (2), wherein a current path (14) having a current strength measuring device (18) for measuring the current strength in the current path (14) is provided between the input (10) and the output (12) and wherein at least one capacitor (16) is connected in the current path (14) of the apparatus (1).

2. System according to claim 1, wherein the battery simulator (2) is suitable for receiving or outputting voltages of greater than 100 volts and/or currents of greater than 100 amps.

3. System according to either of the preceding claims, wherein the battery simulator (2) comprises a current measuring device (32) and/or a voltage measuring device (34).

4. System according to any of the preceding claims, wherein the apparatus (1) can be operated in a motor operating mode and in a generator operating mode, wherein in the motor operating mode the at least one capacitor (16) is charged by the battery simulator (2) and in the generator operating mode the capacitor (16) is discharged into the battery simulator (2), wherein the current strength is measured.

5. System according to any of the preceding claims, wherein an apparatus (19) for measuring the electric voltage is provided in a voltage path (15) between the input (10) and the output (12).

6. System according to any of the preceding claims, wherein a current transformer (20) with a primary and a secondary current is connected in the current path (14), wherein the secondary current runs to the current strength measuring apparatus (18) for measuring the current strength and the primary current runs to the capacitor (16).

7. System according to claim 6, wherein the current strength measuring apparatus (18) for measuring the electrical current strength comprises a measuring resistor (22) to which an apparatus (24) for measuring the electrical voltage is connected in parallel thereto.

8. System according to any of the preceding claims, wherein an input protection means (11) is connected in series downstream of the input (10) in the current path (14) and/or an output protection means (13) is connected in series upstream of the output (12).

9. System according to any of the preceding claims, wherein a communication interface (50) is provided for communication with the battery simulator (2).

10. System according to claim 9, wherein a control circuit can be produced between the battery simulator (2) and the apparatus (1) by means of the communication interface (50), wherein the quantities measured by the apparatus (1) and the quantities measured by the battery simulator (2) are compared continuously and in the event of a deviation of the quantities measured by the battery simulator (2) and by the apparatus (1), the measuring apparatuses (32, 34) of the battery simulator are adjusted according to the quantities measured by the apparatus (1).

11. System according to any of the preceding claims, wherein the at least one capacitor (16) has a total capacitance of more than 10 farads, in particular of more than 100 farads, preferably of more than 1,000 farads.

12. System according to any of the preceding claims, wherein the capacitor (16) comprises at least one electrochemical capacitor, in particular a supercapacitor.

13. Method for calibrating a battery simulator (2) with an apparatus (1) having an input (10) and an output (12) for connecting the battery simulator (2), wherein a current path (14) of which the current strength is measured is provided between the input (10) and the output (12), wherein a capacitor (16) in the current path (14) is at least partially charged by the battery simulator (2) and then the capacitor (16) at least partially charges the battery simulator (2).

14. Method according to claim 13, wherein the current path (14) is interrupted downstream of the input (10) with an input protection means (11) and/or is interrupted upstream of the output (12) with an output protection means (13) when a measurement of the voltage is carried out on a voltage path (15) between the input (10) and the output (12).

15. Calibrating method according to claim 14, wherein a communication interface (50) is used to produce a control circuit to the battery simulator (2) and wherein the quantities measured by the battery simulator (2) are compared with the quantities measured in the voltage path (15) and in the current path (14) and in the event of deviations between the quantities measured by the battery simulator (2) and the quantities measured in the voltage path (15) and in the current path (14), measuring devices (32, 34) of the battery simulator (2) are adjusted according to the quantities measured in the voltage path (15) and in the current path (14).

## Revendications

1. Système, comportant
a) un simulateur de batterie (2) avec une source et un récepteur de tension continue et/ou une source et un récepteur de courant continu (30); et
b) un dispositif (1) qui est configuré pour étalonner le simulateur de batterie (2), et qui comporte une entrée (10) et une sortie (12) pour le raccordement du simulateur de batterie (2), où entre l'entrée (10) et la sortie (12) il est prévu un chemin de courant (14) avec un dispositif de mesure d'intensité du courant (18) pour mesurer l'intensité du courant dans le chemin de courant (14), et où au moins un condensateur (16) est branché dans le chemin de courant (14) du dispositif (1).

2. Système selon la revendication 1, où le simulateur de batterie (2) est approprié pour absorber ou délivrer des tensions supérieures à 100 volts et/ou des courants supérieurs à 100 ampères.

3. Système selon l'une des revendications précédentes, où le simulateur de batterie (2) comporte un ampèremètre (32) et/ou un voltmètre (34).

4. Système selon l'une des revendications précédentes, où le dispositif (1) peut être amené à fonctionner dans un mode de fonctionnement de moteur et dans un mode de fonctionnement de générateur, où dans le mode de fonctionnement de moteur le au moins un condensateur (16) est chargé par le simulateur de batterie (2) et dans le mode de fonctionnement de générateur le condensateur (16) est déchargé dans le simulateur de batterie (2), où l'intensité du courant est mesurée.

5. Système selon l'une des revendications précédentes, où un dispositif (19) pour mesurer la tension électrique dans un chemin de tension (15) entre l'entrée (10) et la sortie (12) est prévu.

6. Système selon l'une des revendications précédentes, où dans le chemin de courant (14) est branché un transformateur de courant (20) avec un courant primaire et un courant secondaire, où le courant secondaire circule vers le dispositif de mesure d'intensité du courant (18) pour mesurer l'intensité du courant et le courant primaire circule vers le condensateur (16).

7. Système selon la revendication 6, où le dispositif de mesure d'intensité du courant (18) présente pour la mesure de l'intensité du courant électrique une résistance de mesure (22) à laquelle un dispositif (24) pour la mesure de la tension électrique est branché en parallèle.

8. Système selon l'une des revendications précédentes, où dans le chemin de courant (14) un contacteur d'entrée (11) est branché en série après l'entrée (10) et/ou contacteur de sortie (13) est branché en série avant la sortie (12).

9. Système selon l'une des revendications précédentes, où une interface de communication (50) est prévue pour la communication avec le simulateur de batterie (2).

10. Système selon la revendication 9, où avec l'interface de communication (50) une boucle de régulation entre le simulateur de batterie (2) et le dispositif (1) peut être établie, où les grandeurs mesurées par le dispositif (1) et les grandeurs mesurées par le simulateur de batterie (2) sont comparées en continu et les dispositifs de mesure (32, 34) du simulateur de batterie sont ajustés conformément aux grandeurs mesurées par le dispositif (1) lors d'un écart des grandeurs mesurées par le simulateur de batterie (2) et par le dispositif (1).

11. Système selon l'une des revendications précédentes, où le au moins un condensateur (16) comporte une capacité totale supérieure à 10 farads, en particulier supérieure à 100 farads, de préférence supérieure à 1000 farads.

12. Système selon l'une des revendications précédentes où le condensateur (16) comporte au moins un condenseur électrochimique, en particulier au moins un supercondensateur.

13. Procédé pour l'étalonnage d'un simulateur de batterie (2) avec un dispositif (1) avec une entrée (10) et une sortie (12) pour le raccordement du simulateur de batterie (2), où entre l'entrée (10) et la sortie (12) un chemin de courant (14) est prévu, dont l'intensité du courant est mesurée, où un condensateur (16) dans le chemin de courant (14) est chargé au moins en partie par le simulateur de batterie (2), puis le condensateur (16) charge au moins en partie le simulateur de batterie (2).

14. Procédé selon la revendication 13, où le chemin de courant (14) est interrompu après l'entrée (10) avec un contacteur d'entrée (11) et/ou avant la sortie (12) avec un contacteur de sortie (13) lorsqu'une mesure de la tension est réalisée sur un chemin de tension (15) entre l'entrée (10) et la sortie (12).

15. Procédé d'étalonnage selon la revendication 14, où à l'aide d'une interface de communication (50) une boucle de régulation vers le simulateur de batterie (2) est réalisée et où les grandeurs mesurées par le simulateur de batterie (2) sont comparées avec les grandeurs mesurées dans le chemin de tension (15) et dans le chemin de courant (14) et en cas de divergences entre les grandeurs mesurées par le simulateur de batterie (2) et les grandeurs mesurées dans le chemin de tension (15) et dans le chemin de courant (14) les appareils de mesure (32, 34) du simulateur de batterie (2) sont ajustés conformément aux grandeurs mesurées dans le chemin de tension (15) et dans le chemin de courant (14).
